# FASCICULE DE BREVET EUROPEEN

(11) **EP 3 425 657 B1**
(45) Date de publication et mention de la délivrance du brevet: **06.11.2024**
(21) Numéro de dépôt: 18180674.6
(22) Date de dépôt: 29.06.2018
(51) Int. Cl.: H01L 21/56, H01L 21/683, H01L 21/78, H01L 21/20

(54) **PROCÉDÉ DE RÉALISATION D'UNE INTERFACE DESTINÉE À ASSEMBLER TEMPORAIREMENT UN SUPPORT MICROÉLECTRONIQUE ET UNE POIGNÉE DE MANIPULATION, ET INTERFACE D'ASSEMBLAGE TEMPORAIRE**
VERFAHREN ZUR HERSTELLUNG EINER SCHNITTSTELLE FÜR DIE TEMPORÄRE MONTAGE EINES MIKROELEKTRONISCHEN SUPPORTS UND EINES BEDIENUNGSGRIFFS, UND ENTSPRECHENDE TEMPORÄRE MONTAGESCHNITTSTELLE
METHOD FOR PRODUCING AN INTERFACE FOR TEMPORARILY JOINING A MICROELECTRONIC SUPPORT AND A CONTROL HANDLE, AND TEMPORARY ASSEMBLY INTERFACE

(30) Priorité: 03.07.2017 FR 1756269
(43) Date de publication de la demande: 09.01.2019
(73) Titulaire: Commissariat à l'Energie Atomique et aux Energies Alternatives, 75015 Paris (FR)
(72) Inventeur: CHARBONNIER, Jean, 38000 GRENOBLE (FR); GAILLARD, Frédéric-Xavier, 38500 VOIRON (FR)
(74) Mandataire: Brevalex

(56) Documents cités:
- US-A1- 2001 039 103
- US-A1- 2003 008 437
- US-A1- 2008 223 285
- US-A1- 2011 204 361
- US-B1- 6 503 778

## Description

### DOMAINE TECHNIQUE ET ÉTAT DE LA TECHNIQUE ANTÉRIEURE

La présente invention se rapporte à un procédé de réalisation d'une interface destinée à assembler temporairement deux éléments, par exemple une poignée de manipulation et un support microélectronique, à un procédé de réalisation d'au moins un dispositif microélectronique, et à une interface d'assemblage temporaire d'au moins deux éléments.

Dans le domaine de la microélectronique, en particulier dans le cadre du packaging et de l'intégration 3D, on met en oeuvre un élément, appelé poignée de transport, permettant de manipuler un substrat aminci, par exemple en silicium en vue de réaliser un dispositif microélectronique sur le substrat.

Par exemple les poignées de transport peuvent être mises en oeuvre dans la réalisation d'étapes de fabrication des puces, par exemple des via traversants ou TSV (Through Silicon Via en terminologie anglo-saxonne) dits last.

Les poignées dites temporaires sont par exemple réalisées dans une plaque de verre ou de silicium.

L'assemblage de la poignée et du substrat est réalisé :
- soit par un collage mettant en oeuvre des matériaux organiques, par exemple, polymères. Ce collage est avantageux car il permet le retrait de la poignée par simple chauffage à environ 200°C. En revanche il n'est pas utilisable si on souhaite réaliser des procédés à des températures au-delà de 350°C-400°C. En outre, le matériau de collage doit être étalé sur chaque poignée, ce qui implique des coûts de revient non négligeables,
- soit par collage direct ou métallique/eutectique. Ce collage présente l'avantage d'être résistant à des températures supérieures à 400°C et peut donc être utilisé pour des procédés microélectroniques mettant en oeuvre des températures au-delà de 400°C. Mais ce collage est permanent, en effet il n'existe pas de méthode industrielle permettant le retrait de la poignée sans sa destruction. Le retrait de la poignée est alors réalisé par sa consommation par érosion mécanique. La poignée ne peut donc être réutilisée.

Les documents FR2773261 et FR2795865 décrivent des procédés de transfert de films minces. Les films minces sont réalisés sur un substrat, des inclusions sont formées dans le substrat à distance du film mince. Des espèces gazeuses sont ensuite implantées dans les inclusions formant alors des microcavités qui déterminent un plan de fracture. Ce procédé est relativement complexe car il comporte notamment l'étape d'implantation des espèces gazeuses.

Le document CA2225131 décrit un procédé de transfert d'une couche porteuse sur un film flexible comportant le collage d'un film flexible sur un substrat comportant une couche poreuse et ensuite le pelage du film flexible, qui emporte avec lui une partie de la couche poreuse. Cette technique ne peut s'appliquer que dans le cas d'un film flexible et ne peut s'appliquer à un support comportant des dispositifs microélectroniques ou à une poignée.

Le document US 2008/223285 A1 décrit un procédé de fragilisation d'une couche par la diffusion d'hydrogène.

### EXPOSÉ DE L'INVENTION

C'est par conséquent un but de la présente invention d'offrir une interface d'assemblage temporaire de deux éléments dans un procédé microélectronique, permettant une séparation aisée des deux éléments, et offrant un assemblage présentant une tenue suffisante aux températures mises en oeuvre habituellement dans les procédés de la microélectronique.

Le but précédemment énoncé ci-dessus est atteint par un empilement de couches destiné à former une interface entre un premier élément, par exemple une poignée temporaire, et un deuxième élément, par exemple un support microélectronique, ledit empilement comportant au moins une première couche de matériau et une deuxième couche de matériau, la première couche étant apte à émettre par dégazage un espèce chimique lors d'un traitement physico-chimique, et la deuxième couche étant apte à recevoir ladite espèce de sorte à fragiliser mécaniquement l'interface et à permettre une séparation facilitée entre le premier élément et le deuxième élément.

Grâce à l'invention, l'assemblage entre la poignée et le support microélectronique est réalisé sans collage mettant en oeuvre des matériaux organiques, il est donc possible, lors de l'intégration, d'utiliser des procédés microélectroniques impliquant des températures supérieures ou égales à 400°C. Il offre en outre l'avantage de permettre de récupérer la poignée et donc de la réutiliser en vue de la fabrication d'autres dispositifs microélectroniques. Il en résulte un gain important en termes de coût de matière et de temps, le procédé ne nécessitant plus d'étaler le matériau de collage sur chaque poignée.

En d'autres termes, on réalise un empilement d'au moins deux couches dont l'une au moins est apte, du fait d'un traitement physico-chimique, à libérer au moins un agent chimique fragilisant au moins en partie l'autre couche. On intègre donc dans l'interface les moyens de sa fragilisation qui seront « activés » au moment souhaité.

La fragilisation peut avoir lieu dans la deuxième couche ou au niveau de la zone de contact entre les deux couches.

Le procédé de réalisation de l'interface d'assemblage temporaire de séparation est défini dans la revendication 1.

Dans un mode de réalisation, la fragilisation est au moins en partie chimique, l'au moins une espèce chimique dégagée par la première couche réagit avec au moins une partie de la deuxième couche pour former un ou des matériaux fragiles, de sorte à réaliser une interface permettant une séparation facilitée entre le premier élément et le deuxième élément.

Dans un autre mode de réalisation, la fragilisation est au moins en partie physique, le premier matériau dégaze au moins une espèce chimique reçue dans la deuxième couche, par un effet de surpression, la deuxième couche est au moins en partie fragilisée.

Par exemple la première couche comporte du silicium amorphe, la deuxième couche est du silicium poreux et le traitement physico-chimique est un traitement thermique à une température inférieure à 500°C. Lors du traitement thermique, le silicium amorphe dégaze de l'hydrogène qui diffuse dans le silicium poreux. Par des réactions d'oxydo-réduction, le silicium poreux est fragilisé. Un phénomène de surpression peut également apparaître favorisant davantage cette fragilisation.

Le traitement de fragilisation peut être réalisé avant, après, voire pendant les étapes technologiques pour réaliser le dispositif microélectronique.

Enfin le premier élément et le deuxième élément sont séparés.

Avantageusement la deuxième couche peut subir un traitement préalable pour la rendre plus sensible à la ou aux espèces chimiques libérées par la première couche.

La présente invention a alors pour objet un procédé de réalisation d'une interface destinée à assembler temporairement un premier et un deuxième élément, comportant au moins :
a) formation d'une première couche comportant au moins un matériau apte à libérer par dégazage au moins une espèce chimique sous l'action d'un traitement physico-chimique,
b) formation d'une deuxième couche comportant au moins un matériau apte à recevoir l'au moins une espèce chimique de sorte à provoquer sa fragilisation,

la première couche et une deuxième couche étant au moins en partie en contact,
la formation de la première couche étant telle que la au moins une espèce chimique est piégée dans le matériau de la couche.

La deuxième couche peut être au moins en partie poreuse.

Dans un exemple, lors de la formation de la deuxième couche, une zone extérieure offrant une porosité inférieure à une zone centrale est réalisée, dite zone d'exclusion.

Dans un exemple de réalisation, l'étape a) est réalisée par dépôt de silicium amorphe par CVD ou PECVD, et la deuxième couche est au moins en partie en silicium poreux

Le procédé de réalisation peut comporter un traitement chimique de la deuxième couche, parmi une oxydation par plasma, une oxydation par voie liquide, telle que l'oxydation en milieu peroxyde..., un traitement d'oxydation gazeuse, un traitement d'oxydation thermique...

La présente invention a également pour objet un procédé d'assemblage temporaire d'un premier élément et d'un deuxième élément comportant :
- la réalisation d'une interface selon le procédé selon l'invention,
- l'assemblage du premier élément et du deuxième élément par l'intermédiaire de ladite interface de sorte que la première couche soit du côté du deuxième élément et le deuxième couche soit du côté du premier élément.
- une étape de fragilisation de l'interface telle que la au moins une espèce est libérée de la première couche et réagit avec tout ou partie du matériau de la deuxième couche.

La deuxième couche est par exemple réalisée en face avant du premier élément.

Dans un exemple, l'étape de fragilisation a lieu avant l'assemblage.

Avantageusement, à l'issu de l'étape de fragilisation l'énergie d'adhérence le long d'un plan transversal à une direction d'empilement des première et deuxième couches est inférieure ou égale à 1 J/m2.

L'étape de fragilisation peut être un traitement thermique entre 250°C et 500°C.

La présente invention a également pour objet un procédé de réalisation d'au moins une partie d'au moins un dispositif microélectronique mettant en oeuvre le procédé d'assemblage selon l'invention, dans lequel le premier élément est une poignée temporaire et le deuxième élément est un support microélectronique, ledit procédé comportant une étape de retrait de la poignée après l'étape de fragilisation.

La présente invention a également pour objet un procédé de réalisation d'un film mince mettant en oeuvre le procédé d'assemblage selon l'invention, dans lequel le premier élément est un substrat support et le deuxième élément est un film mince, ledit procédé comportant une étape de retrait du substrat support après l'étape de fragilisation.

La présente invention a également pour objet une interface destinée à assembler temporairement un premier et deuxième élément comportant au moins une première couche comportant au moins un matériau apte à libérer au moins une espèce chimique par dégazage sous l'action d'un traitement physico-chimique, la au moins une espèce chimique étant piégée dans le matériau de la première couche (C1) lors de la formation de ladite couche, et au moins une deuxième couche comportant au moins un matériau apte à recevoir le ou les espèces chimiques libérée par la première couche, la ou lesdites espèces chimiques diffusant de la première couche vers la deuxième, de sorte à provoquer sa fragilisation.

Par exemple, la première couche est en silicium amorphe et la deuxième couche est en silicium poreux.

De manière avantageuse, la deuxième couche a une porosité comprise entre 20% et 80%.

L'épaisseur de la première couche peut être comprise entre 100 nm et 10 µm et celle de la deuxième couche peut être comprise entre 100 nm et 100 µm.

L'interface peut également comporter une couche d'encapsulation recouvrant la première couche, par exemple en SiO2.

### BRÈVE DESCRIPTION DES DESSINS

La présente invention sera mieux comprise sur la base de la description qui va suivre et des dessins en annexe sur lesquels:
- la figure 1 est une représentation schématique d'un exemple d'une interface d'assemblage temporaire selon l'invention,
- la figure 2 est une représentation schématique d'un autre exemple d'une interface d'assemblage temporaire selon l'invention,
- les figures 3A et 3B sont des vues de coupes en microscopie électronique à balayage d'un exemple d'interface selon l'invention avant et après un traitement de fragilisation respectivement,
- la figure 4A est une vue en coupe en microscopie électronique à balayage d'un empilement d'une couche de silicium poreux et de SiO₂ avant un traitement thermique,
- la figure 4B est une vue en coupe en microscopie électronique à balayage d'un empilement d'une couche de silicium poreux et de SiO₂ après un traitement thermique, l'épaisseur de la couche de SiO₂ étant plus faible que sur la figure 4A car l'échantillon a subi une étape de polissage mécano-chimique de son oxyde de silicium en plus du traitement thermique,
- la figure 5A est une vue de différents empilements comportant du silicium poreux et du SiO₂ après un traitement thermique à 400°C sous N2 pendant 2h,
- la figure 5B est une vue de différentes interfaces selon l'invention comportant une couche de silicium poreux et une couche de silicium amorphe après un traitement thermique à 400°C sous N₂ pendant 2h,
- les figures 6A à 6I sont des représentations schématiques des étapes d'un exemple de procédé de réalisation d'un dispositif de type FO-WLP selon l'invention,
- les figures 7A à 7D sont des représentations schématiques des étapes d'une variante du procédé de réalisation des figures 6A à 6I,
- les figures 8A à 8H sont des représentations schématiques des étapes d'un exemple de procédé pour réaliser un dispositif microélectronique comportant des TSV last en vue d'une intégration 3D selon l'invention.

### EXPOSÉ DÉTAILLÉ DE MODES DE RÉALISATION PARTICULIERS

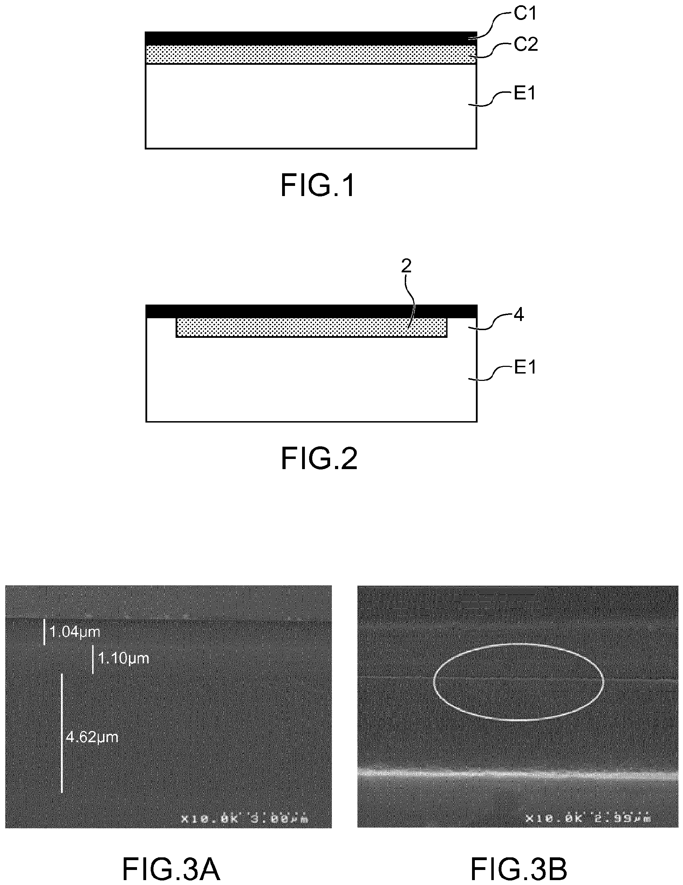

Sur la figure 1, on peut voir un exemple de réalisation d'un empilement comportant l'interface selon l'invention.

L'empilement comporte un premier élément E1, par exemple une poignée temporaire de manipulation, et une interface I formée sur la poignée E1. L'interface comporte une première couche C1 et une deuxième couche C2, la couche C2 étant du côté du premier élément E1.

Dans l'exemple représenté, la couche C1 et la couche C2 sont directement en contact. Selon une variante, les couches C1 et C2 peuvent n'être qu'en partie en contact direct. Selon une variante encore, une couche peut être interposée entre tout ou partie des couches C1 et C2, par exemple une couche « perméable » aux espèces chimiques libérées par la couche C1 soit interposée entre les couches C1 et C2.

La poignée est par exemple réalisée à partir d'un substrat en silicium.

La couche C1 comporte au moins un matériau apte à libérer une ou plusieurs espèces chimiques sous l'action d'un traitement physico-chimique et la couche C2 comporte au moins un matériau apte à recevoir le ou les espèces chimiques de sorte à provoquer sa fragilisation.

Dans la présente demande on entend par l'«aptitude à recevoir une espèce chimique », le fait d'être le siège de toute réaction physique et/ou chimique avec l'espèce chimique, par exemple une adsorption et/ou une absorption et/ou une réaction d'oxydo-réduction.

La quantité d'espèces chimiques piégées dans la couche C1 dépend, de manière non limitative, des conditions et paramètres du procédé de dépôt, tels que la température de dépôt, le ratio de gaz..., de son épaisseur...La couche C2 est telle qu'elle favorise la diffusion des espèces chimiques dans son volume. De manière très avantageuse, la couche C2 est poreuse au moins en partie.

Le procédé de réalisation de l'interface d'assemblage temporaire comporte les étapes :
- formation d'une couche C1 comportant au moins un matériau apte à libérer une ou plusieurs espèces chimiques sous l'action d'un traitement physico-chimique,
- formation d'une couche C2 comportant au moins un matériau apte à recevoir le ou les espèces chimiques de sorte à provoquer sa fragilisation,
   les couches C1 et C2 étant au moins en partie en contact,
- éventuellement une étape de fragilisation.

La couche C1 peut être réalisée avant ou après la couche C2.

La couche C1 a par exemple une épaisseur comprise entre 100 nm et 10 µm, avantageusement égale à environ 1 µm.

L'étape de fragilisation peut provoquer une modification physico-chimique de la couche C2 et/ou une modification structurelle de la couche C2 du fait d'une surpression qui lui serait appliquée.

L'empilement peut par exemple être interposé entre une poignée E1 et un ou des dispositifs microélectroniques.

Dans un exemple de réalisation, la couche C2 subit un traitement favorisant la ou les réactions physiques et/ou chimiques avec les espèces chimiques libérées par la couche C1.

Un exemple particulier d'empilement va maintenant être décrit.

La première couche C1 est en silicium amorphe, la deuxième couche C2 est en silicium poreux et la poignée E1 est un substrat en silicium.

La deuxième couche C2 est réalisée directement en face avant de la poignée E1, par exemple par attaque électrochimique en milieu acide fluorhydrique. Cette technique est bien connue de l'homme du métier. Le document « Formation and application of porous silicon », Material Science and Engineering R 39(2002) 93-141 décrit différentes techniques électrochimiques de formation de silicium poreux.

La couche poreuse C2 peut être obtenue soit à partir de films à porosité constitutive pour lesquels la porosité est issue directement de la synthèse, par exemple la silice poreuse obtenue par procédé sol-gel type aérogel à base de silicium, par voie électrochimique permettant de former des matériaux métalliques poreux, tels que l'alumine poreuse, le silicium poreux..., soit à parti de films qui sont ensuite rendus poreux par porosité soustractive pour lesquels la porosité résulte de la dégradation sélective d'une partie contenue dans la couche à porosifier, appelée porogène. Ces porogènes sont par exemple des macromolécules organiques (polymères, sucres, tensioactifs) éliminés en utilisant des procédés de calcination, oxydation douce (plasma, UV, ozone), des traitements thermiques ou solubilisation.

La couche C2 peut être réalisée à partir d'un ou puiseurs matériaux organiques, des matériaux inorganiques, par exemple un matériau diélectrique poreux à base d'hydrogène ou de méthyl silsesquioxane.

Le taux de porosité, la taille des pores et l'épaisseur de la couche poreuse peuvent être déterminées en choisissant la nature du substrat silicium utilisé, par exemple en choisissant son type p ou n, son niveau de résistivité et les conditions du procédé, parmi par exemple la solution électrolytique, le niveau de courant, le niveau de tension, l'illumination, la durée... Ainsi, des structures présentant des nano cristallites homogènes ou formées de piliers entrelacées de silicium peuvent être obtenues.

La couche poreuse C2 comporte de préférence une taille de pores comprise entre quelques nanomètres et plusieurs dizaines de nanomètres, et de préférence un taux de porosité compris entre 20% et 80%. Les méthodes de mesure de porosité sont bien connues de l'homme du métier. Par exemple, l'une des méthodes utilise plusieurs mesures de pesée : une mesure de pesée (M1) avant porosification, une mesure de pesée après porosification (M2) et une mesure de pesée après retrait de la couche poreuse (M3). Ces trois valeurs M1, M2, M3 permettent de déduire mathématiquement l'épaisseur et le taux de porosité de la couche de silicium poreux. Une autre méthode utilise les mesures de pesée avant et après porosification et la mesure d'épaisseur de la couche poreuse pour déterminer le taux de porosité. L'épaisseur de la couche poreuse est par exemple mesurée par observation d'une coupe de la couche au microscope électronique à balayage.

La couche de silicium poreux C2 a par exemple une épaisseur comprise entre 100 nm et 100 µm, avantageusement égale à environ 5 µm. Une couche C2 en silicium poreux est particulièrement adaptée dans le cadre de procédés micro et nanotechnologiques, qui utilisent principalement des substrats silicium.

Dans un exemple avantageux, la couche C2 peut subir un ou des traitements physico-chimiques avant son assemblage avec la couche C1, afin de modifier superficiellement ou en profondeur la nature chimique même du matériau poreux, par exemple les traitements physico-chimiques peuvent être un traitement d'oxydation par exemple par plasma oxydant, par voie liquide, tel que l'oxydation en milieu peroxyde..., un traitement d'oxydation gazeuse, un traitement d'oxydation thermique... De tels traitements peuvent permettre de favoriser la réaction avec les espèces chimiques libérées par la couche C1 afin de faciliter l'étape de fragilisation.

Dans un exemple de réalisation représenté sur la figure 2, la couche C2 est en partie poreuse. Elle comporte une portion centrale 2 poreuse et une portion périphérique extérieure dense 4 entourant de manière continue la portion poreuse 2. La portion périphérique dense 4 est telle qu'elle permet de piéger, au moins temporairement, les espèces chimiques libérées par la couche C1 dans la portion poreuse 2, ainsi elles restent au moins en partie confinées dans la portion poreuse 2, ce qui favorise la ou les réactions avec le ou les matériaux de la portion poreuse. En outre, elle protège la couche poreuse et assure un maintien mécanique de l'empilement dans le cas où la couche poreuse serait très fragilisée et assure une cohésion de l'ensemble poignée-dispositifs lors des procédés technologiques appliqués à l'empilement.

La portion extérieure 4, désignée zone d'exclusion, a par exemple une épaisseur de quelques millimètres, de préférence de l'ordre de 3 mm.

Cette zone d'exclusion peut avantageusement être formée directement lors du procédé de porosification de la couche C2, en utilisant la zone d'exclusion intrinsèque à certains procédés de porosification, mettant en oeuvre par exemple un système double cuve, soit par masquage.

La couche C1 en silicium amorphe est formée sur la couche C2. La couche C1 en silicium amorphe est telle qu'elle libère de l'hydrogène gazeux lorsqu'elle est soumise à une température suffisante, par exemple comprise entre 250°C et 500°C avantageusement égale à 350°C. La couche C1 est par exemple déposée sur la couche C2 par PVD, par dépôt chimique en phase vapeur (CVD pour Chemical Vapor Deposition en terminologie anglo-saxonne), et avantageusement par CVD assistée par plasma (PECVD pour Plasma Enhanced Chemical Vapor Déposition) à une température comprise entre 150°C et 400°C, avantageusement égale à environ 240°C. Dans le cas du dépôt PECVD, le piégeage de l'hydrogène résulte de la décomposition du précurseur dans la couche. La couche C1 a par exemple une épaisseur comprise entre 100 nm et 10 µm, avantageusement égale à environ 1 µm.

Lors d'une étape suivante, l'interface subit un traitement visant à fragiliser mécaniquement l'interface et en particulier la couche C2.

Dans la présente demande, on entend par « traitement de fragilisation », un traitement visant à obtenir une énergie d'adhésion de l'empilement des couches C1 et C2 par rapport au substrat silicium inférieure ou égale à environ 1 J/m² après le traitement. Dans le cas d'une interface silicium amorphe/silicium poreux, l'énergie d'adhésion est supérieure à 2 J/m².

L'énergie d'adhésion est mesurable par des techniques bien connues de l'homme du métier, par exemple par insertion de lame ou mesure de flexion 4 pointes.

Le traitement thermique est à basse température, ce qui est compatible avec le ou les dispositifs microélectroniques produits sur la couche C1.

Lors du traitement thermique, le silicium amorphe libère de l'hydrogène gazeux dont au moins une partie va entrer en contact avec la couche C2 et réagir avec le silicium poreux et fragiliser celui-ci, ce qui permet ensuite de retirer la poignée E1 par fracturation au niveau des couches C1 et C2.

Lors de la libération de l'hydrogène et de sa réaction avec le silicium poreux, la couche C2 en silicium poreux forme avantageusement une couche tampon permettant de conserver la planéité de l'empilement, et éviter le bullage ou les cloques et les défauts de planéité qui en résulteraient. En l'absence de couche C2, il existe un risque que des cloques apparaissent au niveau de la couche C1 empêchant une intégration ultérieure du fait des défauts de planéité.

Dans l'exemple d'une interface comportant du silicium amorphe et du silicium poreux, le traitement de fragilisation est avantageusement un traitement thermique à des températures comprises entre 250°C et 500°C et avantageusement égales à environ 350°C. Le traitement thermique est avantageusement réalisé sous atmosphère d'azote.

La durée du traitement thermique peut être comprise entre 10 min et 10 heures, de préférence elle est de l'ordre de 2h. La durée du traitement thermique dépend en autres choses de l'épaisseur des couches C1 et C2.

A la fin du traitement thermique, il n'est pas requis que des réactions avec les espèces chimiques libérées par la couche C1 aient eu lieu dans tout le volume de la couche C2, notamment dans toute la section transversale de la couche C2. Il peut être suffisant qu'une zone partielle en surface, en volume et/ou en épaisseur de la couche C2 en contact avec la couche C1 ait réagi pour permettre la séparation. Il peut également s'agir d'une zone disposée à distance de la couche C1; dans ce cas lors de la séparation une partie de la couche C2 reste sur la couche C1. En effet, on cherche à fragiliser l'interface C1 et C2 par les réactions avec les espèces chimiques libérées par la couche C1 et réagissant avec le couche C2.

Dans une variante de réalisation, la couche C2 peut comporter des motifs non poreux, par exemple obtenus par masquage de certaines zones de la couche poreuse C2 par procédé de lithographie. Ces motifs non poreux peuvent permettre de renforcer l'interface.

Sur les figures 3A et 3B, on peut voir des coupes en microscopie électronique à balayage de l'empilement de la figure 1 avec l'élément E1 en Si, la couche C2 en silicium poreux et la couche C1 en silicium amorphe avant et après un traitement thermique à 400°C sous N2 pendant 2 h respectivement. On constate l'apparition d'une zone fragilisée 6. La zone fragilisée 6 apparaissant pendant le traitement thermique se situe à l'interface entre la couche C1 et la couche poignée C2.

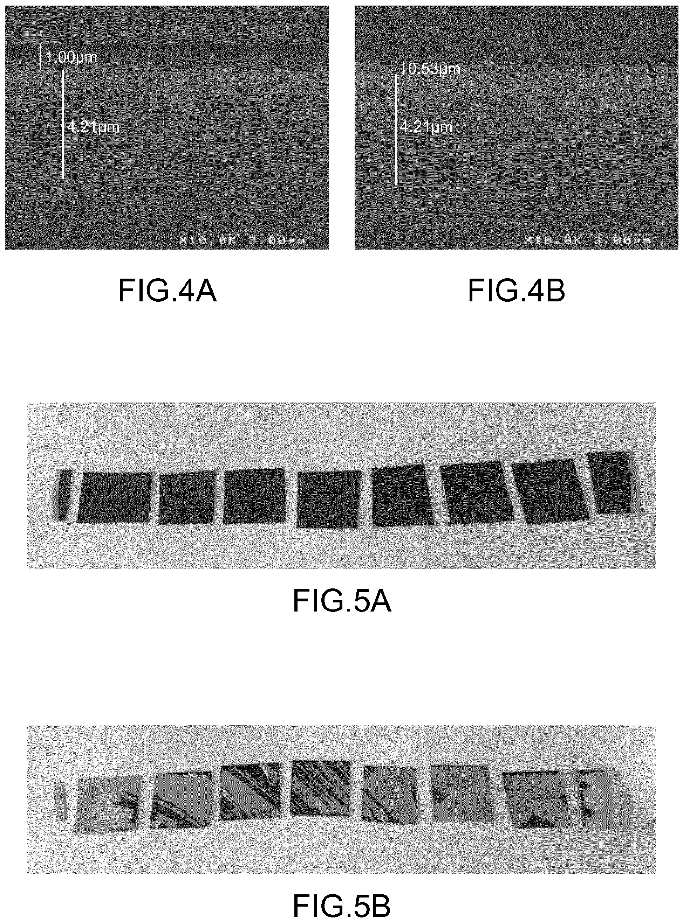

A titre de comparaison, sur les figures 4A et 4B, on peut voir des coupes en microscopie électronique à balayage de l'empilement de la figure 1, avec un l'élément E1 en Si, une couche C2 en silicium poreux et une couche C1' en SiOz déposée par PECVD, avant et après un traitement thermique à 400°C sous N2 pendant 2 h respectivement.

Aucune zone de fragilisation n'est apparue suite au traitement thermique.

Sur la figure 5B, on peut voir des vues optiques d'empilements Si poreux, Si amorphe après un traitement thermique à 400°C sous N₂ pendant 2h, on constate que la couche C1 s'effrite en lamelles (visible sur la photo 5B). Alors que la figure 5A représentant des vues optiques d'empilements Si poreux, SiOz après un traitement thermique à 400°C sous N2 pendant 2h, on ne constate aucune modification.

Le traitement de fragilisation est avantageusement réalisé à faibles températures, de préférence inférieures à 500°C. Il assure la fragilisation de la couche C2 ou de l'interface C1 et C2, ce qui permet d'abaisser l'énergie d'adhérence entre la poignée et la couche C2 à des valeurs de l'ordre de 1 J/m². Avec une telle énergie d'adhérence, le retrait de la poignée est alors possible sans endommagement du support microélectronique.

Avantageusement, le traitement thermique est à 200°C pendant 2h sous atmosphère non contrôlée. La température de l'ordre de 200°C est très intéressante car elle n'est pas destructrice et n'endommage pas les intégrations, notamment les brasures à base d'étain, qui ne supportent pas des températures supérieures à 280°C sans subir de dégradation.

Le traitement de fragilisation peut avoir lieu avant la réalisation ou report des dispositifs microélectroniques sur la couche C1, pendant la réalisation ou report des dispositifs microélectroniques sur la couche C1 ou après la réalisation ou report des dispositifs microélectroniques sur la couche C1.

Par ailleurs, il est envisageable que le traitement de fragilisation soit réalisé simultanément à une étape ou de plusieurs étapes de réalisation du ou des dispositifs microélectroniques, si celle(s)-ci mettent en oeuvre un budget thermique adapté à cette fragilisation.

Il peut résulter du traitement de fragilisation une séparation sans que celle-ci nécessite d'exercer une action mécanique au niveau de l'interface. Dans ce cas, le traitement de fragilisation et de séparation a lieu après réalisation des dispositifs microélectroniques.

Selon un autre exemple de réalisation, le traitement de fragilisation peut être un traitement UV.

Selon un autre exemple de réalisation, le traitement de fragilisation peut comporter un traitement thermique et un traitement UV.

De préférence, le traitement de fragilisation a lieu avant le report des dispositifs sur la couche C1.

La séparation peut être réalisée suivant différentes techniques connues de l'homme du métier, choisies de manière non limitative parmi le pelage, l'utilisation d'un jet d'eau, l'attaque chimique acide, l'attaque chimique alcaline par voie liquide ou gazeuse.

Après séparation, la poignée peut avantageusement être réutilisée, soit en réalisant directement un nouveau dépôt de la couche C1 si toute la couche C2 n'a pas été consommée lors de l'étape de fragilisation précédente, soit en formant une nouvelle couche C2 et un nouvelle couche C1, dans ce cas s'il existe une couche C2 résiduelle, une étape de nettoyage et/ou consommation de celle-ci selon les techniques classiques de la microélectronique (par exemple par immersion dans un bain chimique de SC1, par attaque TMAH,...) a préalablement lieu à la formation d'un nouvelle couche C2.

Les différentes variantes et possibilités, par exemple de traitements physico-chimiques, de fragilisation, de séparation, décrites en relation avec l'exemple ci-dessus dans lequel la couche C1 est en Si amorphe et la couche C2 est en Si poreux s'appliquent aux exemples qui vont suivre. Il sera compris que les traitements sont adaptés en fonction des matériaux et ou des mécanismes de fragilisation mis en oeuvre.

Selon un autre exemple de réalisation, la couche C2 pourrait comporter un ou plusieurs matériaux métalliques ou alliages métalliques non poreux. Ce ou ces matériaux en tout ou partie peuvent par exemple avoir une aptitude à adsorber l'hydrogène dégagé par la couche C1 pour former un hydrure. Par exemple, la couche C2 peut comporter du titane (solution solide TiHα), Vanadium, Nb, Ni ou autre métaux de transitions et alliage de métaux de transitions comme Zr₇Ni₁₀. En effet, l'hydrogène à la capacité de fragiliser les métaux selon un mécanisme bien connu de l'homme du métier, désigné «hydrogen embrittlement», par interaction avec les dislocations du réseau, les atomes d'hydrogène entraînant une diminution importante de la capacité de déformation plastique du métal qui devient fragile et/ou en formant directement un hydrure métallique par précipitation, cet hydrure ayant la propriété d'être cassant. Ces matériaux présentent l'avantage de permettre une bonne migration de l'hydrogène.

Ces matériaux pourraient par exemple être déposés par voie électrochimique, au moyen de techniques de dépôts sous vide, par voie chimique (sol gel...) ou dépôt à la tournette (spin coating en terminologie anglo-saxonne)...En particulier les métaux de transition et leurs alliages sont par exemple déposés par dépôt physique en phase vapeur (ou PVD pour Physical Vapor Deposition en terminologie anglo-saxonne) ou co-PVD.

La couche C1 peut comporter tout matériau capable de libérer ou dégazer de l'hydrogène ou d'autres espèces chimiques lors du traitement de fragilisation. Par exemple, la couche C1 peut comporter des oxydes ou nitrures de silicium déposés à faible température, de préférence inférieure à 200°C, ou des oxy-nitrures de silicium SiOxNy non stoechiométrique aptes à dégazer lors de montées en température supérieures à leur température de dépôt. La température de dépôt des oxy-nitrures est par exemple comprise entre 150°C et 400°C.

Selon un autre exemple, la couche C1 peut libérer du O₂ ou du NH₃.

Lors du procédé de PECVD, la décomposition des précurseurs entraîne la formation d'éléments chimiques (radicaux dits libres type H*, O*) qui peuvent être adsorbés ou se lier via des liaisons de faibles énergie, de type Van der Walls, au matériau de la couche C1.

Lorsque les espèces chimiques libérées sont du H₂, du O₂ et du NH₃, lors de l'étape de fragilisation une ou des réactions d'oxydoréduction ont lieu avec le ou les matériaux de la couche C2.

Selon un autre exemple de réalisation, la couche C1 comporte des polymères à base silicone qui, lorsqu'ils sont chauffés par exemple à au moins 300°C, dégagent des composés organiques volatiles, comme par exemples les porogènes organiques type DEMS (Diethoxymethyloxiranylsilane) et NBD (Norbornadiene), la couche C2 comporte un matériau poreux, par exemple en silicium poreux. Le mécanisme de fragilisation est alors la surpression.

Selon un autre exemple de réalisation, la couche C1 comporte un matériau diélectrique organique, par exemple un polymère, la couche C2 comporte au moins un matériau poreux à base par exemple de Si, du Ge, de SiGe, un diélectrique poreux tel que le SiOz, SiN, SiON, un métal poreux, un matériau organique poreux déposé par exemples par dépôt par voie chimique en phase vapeur initiée ou ICVD (Initiated chemical vapor deposition en terminologie anglo-saxonne), par exemple un polymère poreux.

Lors de l'étape de fragilisation, la couche C1 peut libérer du N₂ ou un ou des hydrocarbures. La fragilisation est obtenue par surpression.

Selon encore un autre exemple de réalisation, il est envisager de réaliser un empilement d'un couche de matériau C1" apte à stocker et à libérer des espèces chimique et une couche de matériau C2 apte à recevoir ces espèces chimiques. Après réalisation de l'empilement les espèces chimiques sont introduites dans la couche C1" pour former une couche C1. Par exemple, on peut réaliser une implantation ionique d'éléments chimique par exemple d'H⁺ dans la couche C1".

Dans un autre exemple de réalisation, on peut prévoir de réaliser la couche C2 par porosification de la face avant de la poignée et de réaliser d'autre part un empilement en vue de la réalisation de dispositifs microélectroniques comportant en face arrière la couche C1, les couches C1 et C2 sont ensuite assemblées.

Dans un exemple particulièrement avantageux, l'empilement comporte une couche supplémentaire dite couche d'encapsulation C3 formée sur la couche C1 à l'opposé de la couche C2. Cette couche assure un confinement au moins partiel des espèces chimiques libérées par la couche C1, forçant celles-ci à diffuser dans la couche C2.

La couche C3 a une épaisseur d'au moins 100 nm et de préférence égale à environ 500 nm. La couche C3 est par exemple en SiN, en SiOz, ou en un matériau diélectrique organique.

La couche d'encapsulation C3 peut être retirée préalablement à la réalisation du ou des dispositifs microélectroniques. Elle peut avantageusement être conservée et servir dans la réalisation du ou des dispositifs microélectroniques.

En outre, la couche d'encapsulation C3 permet avantageusement de reporter un empilement comportant le ou les dispositifs microélectroniques sur l'ensemble poignée et interface d'assemblage. Par exemple une couche C3 en SiO₂ permet un collage oxyde-oxyde, l'empilement microélectronique comportant en face arrière une couche d'oxyde.

Un exemple de procédé de réalisation d'un dispositif de type FO-WLP (Fan Out Wafer Level packaging en terminologie anglo-saxonne) ou conditionnement épanoui à l'échelle du wafer ou de la plaque de silicium, mettant en oeuvre une interface d'assemblage temporaire selon l'invention va maintenant être décrit.

Le FO-WLP consiste à connecter des circuits électroniques hétérogènes dans un même conditionnement ou ensemble comprenant principalement des matériaux dits de moulage.

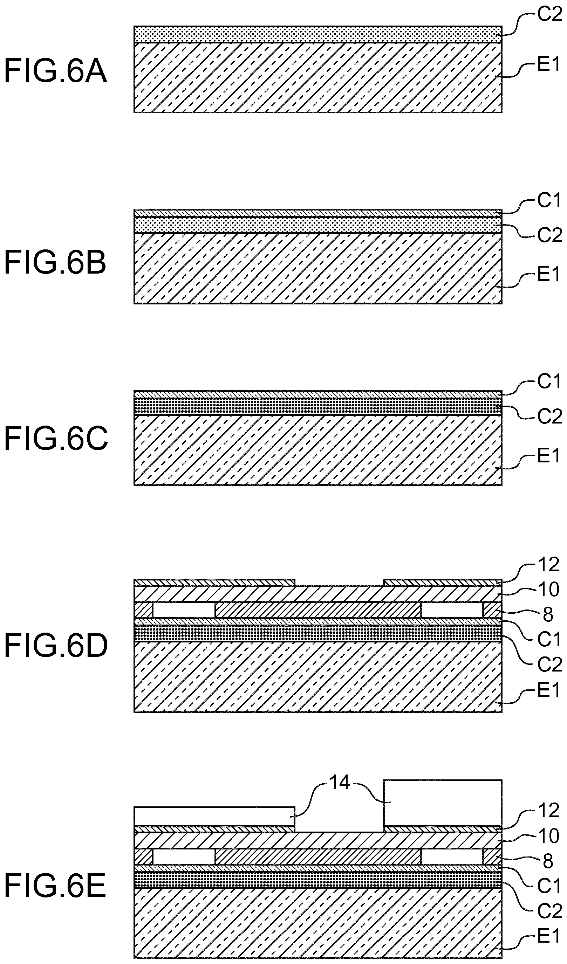

Sur la figure 6A est représenté un ensemble comportant une poignée E1 et la couche C2, formée en face avant de la poignée par exemple par un procédé de porosification.

Lors d'une étape suivante, on forme la couche C1 en silicium amorphe sur la couche C2, par exemple par CVD. L'élément obtenu est représenté sur la figure 6B.

Lors d'une étape suivante, l'élément de la figure 6B subit un traitement de fragilisation. Dans cet exemple, il s'agit d'un traitement thermique à une température comprise de préférence entre 250°C et 500°C. La couche C2 a été fragilisée.

L'élément obtenu est représenté sur la figure 6C.

Lors des étapes 6D à 6G, on réalise le ou les dispositifs microélectroniques sur la couche C1.

Une couche d'accroche 8 sous les billes ou UBM (Under Bump Metallurgy en terminologie anglo-saxonne), une couche de redistribution 10 et des interconnexions inter-puces 12 sont réalisées. L'élément obtenu est représenté sur la figure 6D. La couche 8 est un empilement métallique pouvant comporter du titane, du nickel et de l'or pour obtenir une surface facilitant le billage, grâce à un bon mouillage lors de la refusion des billes, et à une bonne protection contre la corrosion dans l'attente du billage ou du montage sur carte ultérieur

Lors d'une étape suivante on reporte une ou des puces actives 14 sur les interconnexions 12.

L'élément obtenu est représenté sur la figure 6E.

Lors d'une étape suivante, on réalise une étape de surmoulage sur le puces 14 par exemple un matériau 16 comprenant matrice époxy et des billes de silices appelées « fillers ».

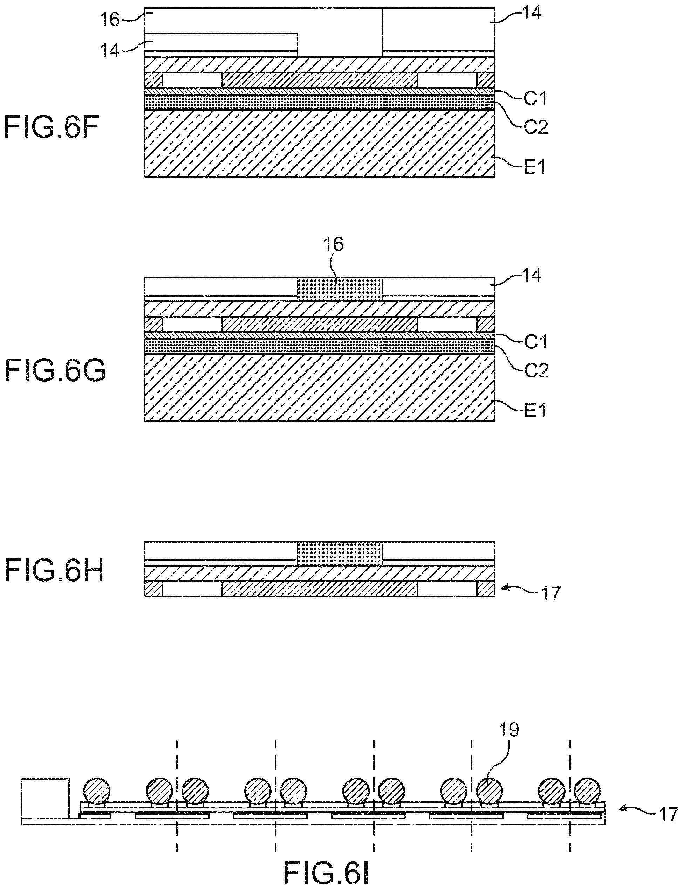

L'élément obtenu est représenté sur la figure 6F.

Lors d'une étape suivante, on réalise un amincissement des puces et du surmoulage.

L'élément obtenu est représenté sur la figure 6G

Lors d'une étape suivante, on retire la poignée E1 par exemple par pelage. La couche C1 résiduelle est retirée par exemple par abrasion.

L'élément 17 obtenu est représenté sur la figure 6H.

Lors d'une étape suivante, la mise en place de billes de connexion 19 sur la face arrière de l'élément de la figure 6H a lieu et l'élément est découpé au niveau des traits en pointillés (figure 6I).

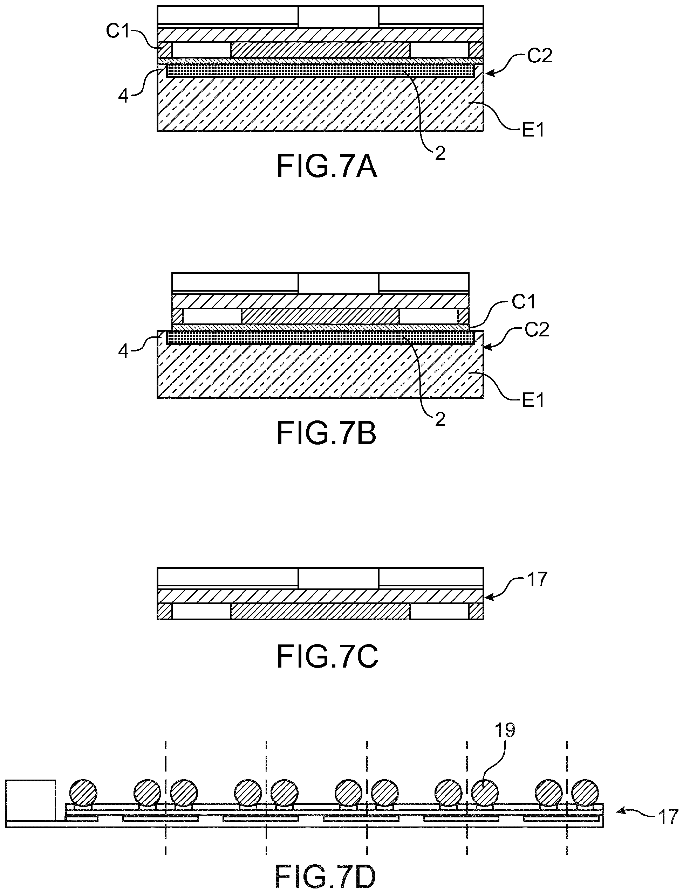

Sur les figures 7A à 7D, on peut voir un autre exemple de procédé mettant en oeuvre une interface d'assemblage temporaire avec une zone d'exclusion.

La zone d'exclusion résulte par exemple du procédé de porosification de la couche C2. On part de l'ensemble poignée - interface de libération représenté sur la figure 2.

Les étapes 6A à 6G décrites ci-dessus sont réalisées. L'élément obtenu est représenté sur la figure 7A.

Lors d'une étape suivante, on prépare l'empilement pour séparer la poignée et l'empilement microélectronique.

On réalise tout d'abord un détourage, par exemple par érosion mécanique, de l'empilement microélectronique et de la couche C1 de sorte à atteindre la zone poreuse de C2.

L'élément obtenu est représenté sur la figure 7B.

Lors d'une étape suivante, on retire la poignée par exemple par pelage.

L'élément obtenu est représenté sur la figure 7C.

Lors d'une étape suivante, on retire la couche C1 et on réalise la mise en place de billes de connexion sur la face arrière de l'élément de la figure 7C et l'élément est découpé au niveau des traits en pointillés (figure 7D).

Ce procédé mettant en oeuvre une interface d'assemblage temporaire selon l'invention, présente par rapport à un procédé FO-WLP dans lequel la poignée est assemblée par une colle polymère, les avantages suivants :
- un coût de fabrication globalement réduit du fait de l'absence de la colle polymère,
- une meilleure tenue à des températures supérieures à 300°C,
- la réalisation d'une intégration avec un système de reroutage dense, par exemple avec des connexions filaires en cuivre ayant des dimensions critiques de l'ordre de 5µm de largeur pour 5 µm d'espace minimum. En effet, grâce à l'invention, l'état de surface sur le silicium amorphe de l'empilement ayant subi un traitement thermique de fragilisation est identique à celui du silicium standard est permet un meilleure contrôle des opérations technologiques de photolithographie, gravure et dépôt comparé à un matériau polymère.

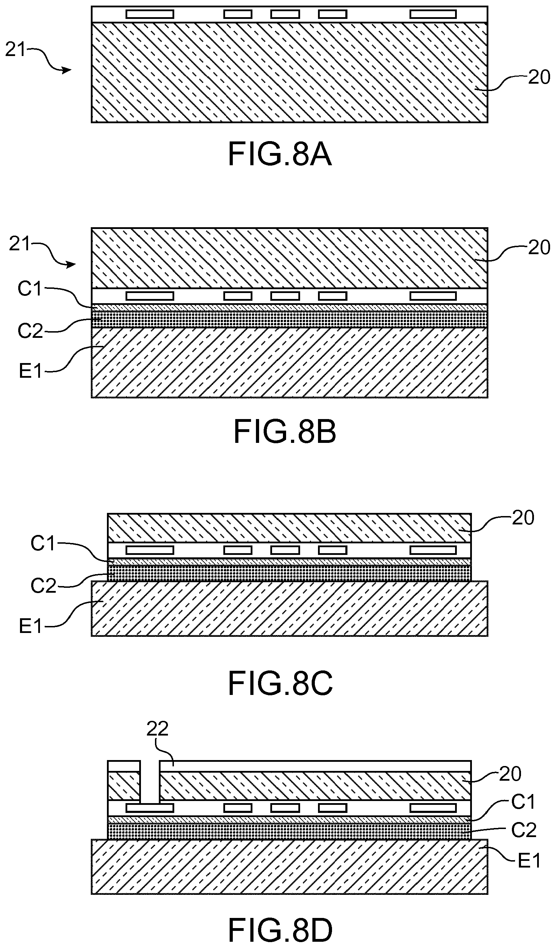

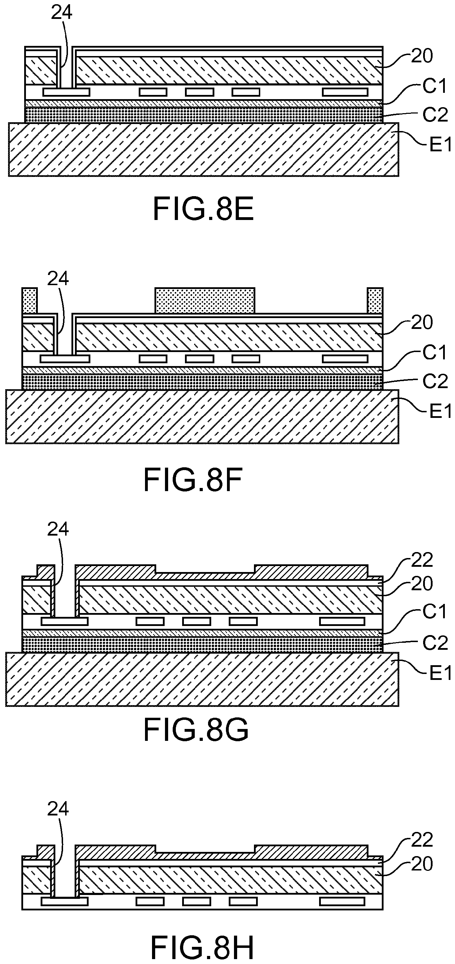

Un exemple de procédé pour réaliser un dispositif microélectronique comportant des TSV last en vue d'une intégration 3D, mettant en oeuvre une interface d'assemblage temporaire selon l'invention, va également être décrit en relation avec les figures 8A à 8H.

Lors d'une première étape, on réalise sur un substrat 20 par exemple en silicium, des transistors et un système de reroutage selon les techniques bien connues de l'homme du métier. L'élément 21 ainsi obtenu est représenté sur la figure 8A.

Par ailleurs, on réalise un ensemble poignée - interface d'assemblage temporaire telle que celle représentée sur la figure 1 ou sur la figure 2 avec une zone d'exclusion. La couche C1 est par exemple en Si amorphe et la couche C2 en Si poreux

Lors d'une étape suivante, on retourne l'élément 218 et on assemble la poignée et l'élément de la figure 8A, par exemple par collage direct ou eutectique en face arrière de l'élément 21. L'élément obtenu est représenté sur la figure 8B. Un traitement de fragilisation peut être appliqué à l'ensemble avant son assemblage avec l'élément 21.

Un traitement de surface adapté peut avoir lieu avant la mise en contact des surfaces à assembler. Un recuit peut être effectué après assemblage afin de permettre une adhésion intime et la réalisation de liaisons chimiques à l'interface.

Dans un exemple avantageux, l'interface d'assemblage temporaire comporte une couche d'encapsulation C3, par exemple en SiO₂, qui participe au collage avec l'élément 18.

Lors d'une étape suivante, le substrat 20 est aminci, par exemple jusqu'à une épaisseur de 200 µm, par exemple par voie de polissage mécano-chimique. L'élément obtenu est représenté sur la figure 8C.

Lors d'une étape suivante, le substrat est gravé pour atteindre les transistors et le système de reroutage. Une couche d'isolation électrique 22 est formée sur le substrat 20 20, la couche 22 est ouverte dans le fond de la gravure pour permettre la connexion aux transistors et au système de reroutage. L'élément obtenu est représenté sur la figure 8D.

Lors des étapes suivantes représentées sur les figures 8E à 8H, on réalise notamment un via traversant 24 ou TSV last process (Through silicon via en terminologie anglo-saxonne) et une reprise de contact. Ces étapes sont bien connues de l'homme de métier et sont par exemple décrites dans le document « Wafer level packaging technology development for cmos image sensors using through silicon vias » J. Charbonnier, Proceedings of ESTC 2009 London*.*

Lors de l'étape représentée sur la figure 8H, la poignée est retirée par exemple par pelage. Dans le cas où l'interface d'assemblage temporaire comporte une zone d'exclusion, une étape de détourage a lieu avant le pelage.

Ce procédé mettant en oeuvre une interface d'assemblage temporaire selon l'invention, présente par rapport à un procédé TSV last dans lequel la poignée est assemblée par une colle polymère, les avantages suivants :
- une libération aisée de la poignée,
- la compatibilité avec des procédés à des températures supérieures à 300°C.

La présente invention peut également être mise en oeuvre dans le transfert d'au moins un film mince de matériau solide délimité dans un substrat initial ou une intégration complète comprenant par exemple un système de routage, des puces reportées et encapsulées dans un matériau de moulage.

## Revendications

1. Procédé de réalisation d'une interface destinée à assembler temporairement un premier et un deuxième élément, comportant au moins :
a) formation d'une première couche (C1) comportant au moins un matériau apte à libérer par dégazage au moins une espèce chimique sous l'action d'un traitement physico-chimique, dans lequel la formation de la première couche (C1) est telle que la au moins une espèce chimique est piégée dans le matériau de la première couche (C1),
b) formation d'une deuxième couche (C2) comportant au moins un matériau apte à recevoir l'au moins une espèce chimique libérée par la première couche, ladite espèce chimique diffusant de la première couche vers la deuxième couche, de sorte à provoquer sa fragilisation,
la première couche (C1) et la deuxième couche (C2) étant au moins en partie en contact.

2. Procédé de réalisation selon la revendication 1, dans lequel la deuxième couche (C2) est au moins en partie poreuse.

3. Procédé de réalisation selon la revendication 2, dans lequel lors de la formation de la deuxième couche (C2), une zone extérieure offrant une porosité inférieure à une zone centrale est réalisée, dite zone d'exclusion.

4. Procédé de réalisation selon l'une des revendications 1 à 3, dans lequel l'étape a) est réalisée par dépôt de silicium amorphe par CVD ou PECVD, et dans lequel la deuxième couche est au moins en partie en silicium poreux

5. Procédé de réalisation selon l'une des revendications 1 à 4, comportant un traitement chimique de la deuxième couche, parmi une oxydation par plasma, une oxydation par voie liquide, telle que l'oxydation en milieu peroxyde, un traitement d'oxydation gazeuse, un traitement d'oxydation thermique.

6. Procédé de réalisation selon l'une des revendications 1 à 5, comportant la réalisation d'un empilement d'une couche (C1") de matériau apte à stocker et à libérer des espèces chimique et de la deuxième couche de matériau (C2) apte à recevoir ces espèces chimiques, et ensuite d'introduction dans la couche (C1") de matériau apte à stocker et à libérer des espèces chimique réalisation de sorte à former la première couche (C1), par exemple on réalise une implantation ionique d'éléments chimique par exemple d'H.

7. Procédé d'assemblage temporaire d'un premier élément (E1) et d'un deuxième élément (E2) comportant :
- la réalisation d'une interface selon le procédé selon l'une des revendications 1 à 6,
- l'assemblage du premier élément (E1) et du deuxième élément (E2) par l'intermédiaire de ladite interface de sorte que la première couche soit du côté du deuxième élément (E2) et la deuxième couche soit du côté du premier élément (E1),
- une étape de fragilisation de l'interface telle que la au moins une espèce est libérée de la première couche (C1) et réagit avec tout ou partie du matériau de la deuxième couche (C2).

8. Procédé d'assemblage selon la revendication 7, dans lequel la deuxième couche est réalisée en face avant du premier élément (E1).

9. Procédé d'assemblage selon la revendication 8, dans lequel l'étape de fragilisation a lieu avant l'assemblage.

10. Procédé d'assemblage selon la revendication 8 ou 9, dans lequel à l'issu de l'étape de fragilisation l'énergie d'adhérence le long d'un plan transversal à une direction d'empilement des première et deuxième couches est inférieure ou égale à 1 J/m2 et/ou dans lequel l'étape de fragilisation est un traitement thermique entre 250°C et 500°C.

11. Procédé de réalisation d'au moins une partie d'au moins un dispositif microélectronique mettant en oeuvre le procédé d'assemblage selon l'une des revendications 8 à 10, dans lequel le premier élément est une poignée temporaire et le deuxième élément est un support microélectronique, ledit procédé comportant une étape de retrait de la poignée après l'étape de fragilisation.

12. Procédé de réalisation d'un film mince mettant en oeuvre le procédé d'assemblage selon l'une des revendications 8 à 10, dans lequel le premier élément est un substrat support et le deuxième élément est un film mince, ledit procédé comportant une étape de retrait du substrat support après l'étape de fragilisation.

13. Interface destinée à assembler temporairement un premier et deuxième élément comportant au moins :
- une première couche (C1) comportant au moins un matériau apte à libérer au moins une espèce chimique par dégazage sous l'action d'un traitement physico-chimique, la au moins une espèce chimique étant piégée dans le matériau de la première couche (C1) lors de la formation de ladite couche,
une deuxième couche (C2) comportant au moins un matériau apte à recevoir la ou les espèces chimiques libérée par la première couche, la ou lesdites espèces chimiques diffusant de la première couche vers la deuxième couche, de sorte à provoquer sa fragilisation.

14. Interface selon la revendication 13, dans laquelle la première couche est en silicium amorphe et la deuxième couche est en silicium poreux, présentant avantageusement une porosité comprise entre 20% et 80%.

15. Interface selon la revendication 13 ou 14, comportant une couche d'encapsulation recouvrant la première couche, par exemple en SiO₂ et/ou dans laquelle l'épaisseur de la première couche est comprise entre 100 nm et 10 µm et celle de la deuxième couche entre 100 nm et 100 µm.

## Patentansprüche

1. Verfahren zur Ausführung einer Grenzfläche, die bestimmt ist, um vorübergehend ein erstes und ein zweites Element zusammenzufügen, mindestens enthaltend:
a) Bilden einer ersten Schicht (C1), die mindestens ein Material enthält, das dazu geeignet ist, durch Entgasung mindestens eine chemische Spezies unter Einwirkung einer physikalisch-chemischen Behandlung freizusetzten, wobei die Bildung der ersten Schicht (C1) derart ist, dass die mindestens eine chemische Spezies im Material der ersten Schicht (C1) eingeschlossen wird,
b) Bilden einer zweiten Schicht (C2), die mindestens ein Material enthält, das dazu geeignet ist, die mindestens eine chemische Spezies, die von der ersten Schicht freigesetzt wurde, aufzunehmen, wobei die chemische Spezies von der ersten Schicht zur zweiten Schicht diffundiert, um ihre Versprödung zu bewirken,
wobei die erste Schicht (C1) und die zweite Schicht (C2) mindestens teilweise in Kontakt stehen.

2. Ausführungsverfahren nach Anspruch 1, wobei die zweite Schicht (C2) mindestens teilweise porös ist.

3. Ausführungsverfahren nach Anspruch 2, wobei während der Bildung der zweiten Schicht (C2) ein äußerer Bereich ausgeführt wird, der eine geringere Porosität aufweist als ein zentraler Bereich, Exklusionsbereich genannt.

4. Ausführungsverfahren nach einem der Ansprüche 1 bis 3, wobei Schritt a) durch Abscheidung von amorphem Silizium durch CVD oder PECVD ausgeführt wird, und wobei die zweite Schicht mindestens teilweise aus porösem Silizium besteht.

5. Ausführungsverfahren nach einem der Ansprüche 1 bis 4, eine chemische Behandlung der zweiten Schicht enthaltend, unter einer Plasmaoxidation, einer Flüssigoxidation, wie Peroxid-Medium-Oxidation, einer gasförmigen Oxidationsbehandlung und einer thermischen Oxidationsbehandlung.

6. Ausführungsverfahren nach einem der Ansprüche 1 bis 5, das Ausführen eines Stapels einer Schicht (C1") aus Material enthaltend, das dazu geeignet ist, chemische Spezies zu speichern und freizusetzen, und der zweiten Schicht aus Material (C2), das dazu geeignet ist, diese chemischen Spezies aufzunehmen, und anschließend an das Einbringen in die Schicht (C1") von Material, das dazu geeignet ist, chemische Spezies zu speichern und freizusetzen, das Ausführen, um die erste Schicht (C1) zu bilden, beispielsweise indem eine lonenimplantation von chemischen Elementen, beispielsweise durch H, ausgeführt wird.

7. Verfahren zum vorübergehenden Zusammenfügen eines ersten Elements (E1) und eines zweiten Elements (E2), enthaltend:
- Ausführen einer Grenzfläche nach dem Verfahren nach einem der Ansprüche 1 bis 6,
- Zusammenfügen des ersten Elements (E1) und des zweiten Elements (E2) mittels der Grenzfläche, so dass die erste Schicht auf der Seite des zweiten Elements (E2) und die zweite Schicht auf der Seite des ersten Elements (E1) ist,
- einen Schritt der Grenzflächenversprödung, so dass die mindestens eine Spezies aus der ersten Schicht (C1) freigesetzt wird und mit dem gesamten oder einem Teil des Materials der zweiten Schicht (C2) reagiert.

8. Verfahren zum Zusammenfügen nach Anspruch 7, wobei die zweite Schicht an der vorderen Seite des ersten Elements (E1) ausgeführt wird.

9. Verfahren zum Zusammenfügen nach Anspruch 8, wobei der Versprödungsschritt vor dem Zusammenfügen erfolgt.

10. Verfahren zum Zusammenfügen nach Anspruch 8 oder 9, wobei nach dem Versprödungsschritt die Haftreibungskraft entlang einer Ebene quer zu einer Stapelrichtung der ersten und zweiten Schicht kleiner oder gleich 1 J/m2 ist, und/oder wobei der Versprödungsschritt eine Wärmebehandlung zwischen 250 °C und 500 °C ist.

11. Verfahren zur Ausführung mindestens eines Teils mindestens einer mikroelektronischen Vorrichtung, das das Verfahren zum Zusammenfügen nach einem der Ansprüche 8 bis 10 implementiert, wobei das erste Element ein vorübergehender Griff und das zweite Element ein mikroelektronischer Träger ist, wobei das Verfahren einen Schritt zum Entfernen des Griffs nach dem Versprödungsschritt enthält.

12. Verfahren zur Ausführung eines Dünnfilms zur Implementierung des Verfahrens zum Zusammenfügen nach einem der Ansprüche 8 bis 10, wobei das erste Element ein Trägersubstrat und das zweite Element ein Dünnfilm ist, wobei das Verfahren einen Schritt zum Entfernen des Trägersubstrats nach dem Versprödungsschritt enthält.

13. Grenzfläche, die bestimmt ist, um vorübergehend ein erstes und zweites Element zusammenzufügen, mindestens enthaltend:
- eine erste Schicht (C1), die mindestens ein Material enthält, das dazu geeignet ist, mindestens eine chemische Spezies durch Entgasung unter Einwirkung einer physikalisch-chemischen Behandlung freizusetzen, wobei die mindestens eine chemische Spezies während der Bildung der Schicht im Material der ersten Schicht (C1) eingeschlossen wird,
eine zweite Schicht (C2), die mindestens ein Material enthält, das dazu geeignet ist, die von der ersten Schicht freigesetzte(n) chemische(n) Spezies aufzunehmen, wobei die chemische(n) Spezies von der ersten Schicht zur zweiten Schicht diffundieren, um ihre Versprödung zu bewirken.

14. Grenzfläche nach Anspruch 13, wobei die erste Schicht aus amorphem Silizium besteht und die zweite Schicht aus porösem Silizium und vorteilhafterweise eine Porosität zwischen 20 % und 80 % aufweist.

15. Grenzfläche nach Anspruch 13 oder 14, eine Verkapselungsschicht enthaltend, die die erste Schicht bedeckt, beispielsweise aus SiO₂, und/oder wobei die Dicke der ersten Schicht zwischen 100 nm und 10 µm liegt und die Dicke der zweiten Schicht zwischen 100 nm und 100 µm.

## Claims

1. Method for producing an interface intended to assemble temporarily a first and a second element, comprising at least:
a) formation of a first layer (C1) comprising at least one material capable of releasing by degassing at least one chemical species under the action of a physical-chemical treatment, wherein the formation of the first layer (C1) is such that the at least one chemical species is trapped in the material of the first layer (C1),
b) formation of a second layer (C2) comprising at least one material capable of receiving the at least one chemical species released by the first layer, said chemical species diffusing from the first layer to the second layer so as to cause its embrittlement,
the first layer (C1) and the second layer (C2) being at least in part in contact.

2. Method according to claim 1, wherein the second layer (C2) is at least in part porous.

3. Method according to claim 2, wherein, during the formation of the second layer (C2), an external zone offering a porosity less than a central zone is produced, known as exclusion zone.

4. Method according to any one of claims 1 to 3, wherein step a) is carried out by deposition of amorphous silicon by CVD or PECVD, and wherein the second layer is at least in part made of porous silicon.

5. Method according to any one of claims 1 to 4, comprising a chemical treatment of the second layer, among an oxidation by plasma, an oxidation by liquid process, such as oxidation in peroxide medium, a gaseous oxidation treatment, a thermal oxidation treatment.

6. Method according to any one of claims 1 to 5, comprising producing a stack of a layer (C1") of material capable of storing and releasing chemical species and of the second layer of material (C2) capable of receiving these chemical species, and then introducing into the layer (C1") a material capable of storing and releasing chemical species so as to form the first layer (C1), for example by an ionic implantation of chemical elements, for example H.

7. Method for assembling temporarily a first element (E1) and a second element (E2) comprising:
- the production of an interface according to the method according to any one of claims 1 to 6,
- the assembly of the first element (E1) and the second element (E2) through said interface such that the first layer is on the side of the second element and the second layer is on the side of the first element (E1),
- as step of embrittlement of the interface such that the at least one species is released from the first layer (C1) and reacts with all or part of the material of the second layer (C2).

8. Assembly method according to claim 7, wherein the second layer is produced on the front face of the first element (E1).

9. Assembly method according to claim 8, wherein the embrittlement step takes place before the assembly.

10. Assembly method according to claim 8 or 9, wherein, at the end of the embrittlement step, the adherence energy along a plane transversal to a stack direction of the first and second layers is less than or equal to 1 J/m² and/or wherein the embrittlement step is a heat treatment between 250°C and 500°C.

11. Method for producing at least one part of at least one microelectronic device implementing the assembly method according to any one of claims 8 to 10, wherein the first element is a temporary handle and the second element is a microelectronic support, said method comprising a step of removal of the handle after the embrittlement step.

12. Method for producing a thin film implementing the assembly method according to any one of claims 8 to 10, wherein the first element is a support substrate and the second element is a thin film, said method comprising a step of removal of the support substrate after the embrittlement step.

13. Interface intended to assemble temporarily a first and second element comprising at least:
- a first layer (C1) comprising at least one material capable of releasing at least one chemical species by degassing under the action of a physical-chemical treatment, the at least one chemical species being trapped in the material of the first layer (C1) during the formation of said layer,
- a second layer (C2) comprising at least one material capable of receiving the one or more chemical species released by the first layer, said chemical species diffusing from the first layer to the second layer so as to cause its embrittlement.

14. Interface according to claim 13, in which the first layer is made of amorphous silicon and the second layer is made of porous silicon and has advantageously a porosity comprised between 20% and 80%.

15. Interface according to claim 13 or 14, comprising an encapsulation layer covering the first layer, for example made of SiO₂, and/or in which the thickness of the first layer is comprised between 100 nm and 10 µm and that of the second layer between 100 nm and 100 µm.
